# EUROPÄISCHE PATENTSCHRIFT

(11) **EP 0 995 148 B1**
(45) Veröffentlichungstag und Bekanntmachung des Hinweises auf die Patenterteilung: **19.11.2008**
(21) Anmeldenummer: 97934449.6
(22) Anmeldetag: 05.07.1997
(51) Int. Cl.: G03F 7/00, G02B 6/12, G03F 7/40

(54) **VERFAHREN ZUR HERSTELLUNG VON AKTIVEN BZW. PASSIVEN KOMPONENTEN AUF POLYMERBASIS FÜR DIE INTEGRIERTE OPTIK**
METHOD FOR PRODUCING ACTIVE OR PASSIVE COMPONENTS ON A POLYMER BASIS FOR INTEGRATED OPTICAL DEVICES
PROCEDE DE PRODUCTION D'ELEMENTS CONSTITUTIFS ACTIFS OU PASSIFS A BASE DE POLYMERE POUR L'OPTIQUE INTEGREE

(43) Veröffentlichungstag der Anmeldung: 26.04.2000
(73) Patentinhaber: Deutsche Telekom AG, 53113 Bonn (DE)
(72) Erfinder: KOOPS, Hans, Wilfried, Peter, D-64372 Ober-Ramstadt (DE)
(86) Internationale Anmeldenummer: PCT/EP1997/003558
(87) Internationale Veröffentlichungsnummer: WO 1999/003021

(56) Entgegenhaltungen:
- EP-A- 0 614 126
- DE-A- 19 616 324
- EHRFELD W ET AL.: "Integrated Optics and Micro-Optics with Polymers" 1993 , B.G. TEUNBER VERLAG , STUTTGART, LEIPZIG XP002058725 & "Deep Proton Irradiation of PMMA for a 3D Integration of Optical Components" K.H. BRENNER ET AL., siehe Seite 159 - Seite 176
- EGUCHI S ET AL: "GRADIENT INDEX POLYMER OPTICAL WAVEGUIDE PATTERNED BY ULTRAVIOLET IRRADIATION" JAPANESE JOURNAL OF APPLIED PHYSICS, Bd. 28, Nr. 12, PART 02, 1.Dezember 1989, Seiten L 2232-2235, XP000100300
- PATENT ABSTRACTS OF JAPAN vol. 013, no. 059 (P-826), 10.Februar 1989 & JP 63 249837 A (FUJITSU LTD), 17.Oktober 1988,
- LAZARE S ET AL: "MICROLENSES FABRICATED BY ULTRAVIOLET EXCIMER LASER IRRADIATION OF POLY(METHYL METHACRYLATE) FOLLOWED BY STYRENE DIFFUSION" APPLIED OPTICS, Bd. 35, Nr. 22, 1.August 1996, Seiten 4471-4475, XP000623802

## Beschreibung

Die erfindungsgemäße Lösung bezieht sich auf die Herstellung von aktiven bzw. passiven optoelektronischen Komponenten auf Polymerbasis. Die zu losende technische Aufgabe besteht in der Entwicklung eines Verfahrens, das auf die Herstellung von passiven und aktiven optoelektronische Komponenten mit hohem Integrationsgrad und großer Packungsdichte ausgerichtet ist. Der Herstellungsprozess soll es ermöglichen, Einfluß in Bezug auf Parameter und Eigenschaften der zu erzeugenden optoelektronischen Komponente zu nehmen, wobei insbesondere der Brechungsindex, die nichtlinear-optische Eigenschaft, die Polarisierbarkeit, die Doppelbrechung und die Verstärkereigenschaften während des Herstellungsprozesses gezielt beeinflußt werden sollen.

Heutige Herstellungsverfahren für Komponenten und Schaltungen der integrierten Optik basieren, wie bei
1.] R. Kashyap, in "Photosensitive Optical Fibers: Devices and Applications", Opt. Fibres Techn. 1, S.17-34 (1994) beschrieben, auf der Glasfasertechnologie, die eine "all-fiber"-Lösung für die in der Telekommunikation benötigten Schaltungen anstrebt.Dabei werden integriert-optische Wellenleiterschaltungen zusammen mit aktiven und passiven Komponenten auf teueren Halbleitersubstraten mit noch teuerer Molekularstrahl-Epitaxie oder metallorganischer Deposition aus der Dampfphase aufgebaut, um die in der Telekommunikation geforderten optischen Schaltungen zu realisieren. Eine Beschreibung derartiger Verfahren ist den nachfolgenden Quellen zu entnehmen:
2.] C. Cremer, H. Heise, R. März, M. Schienle, G. Schulte-Roth, H. Unzeitig, "Bragg Gratings on InGaAsP/InP-Waveguides as Polaization Independent Optical Filters" J. of Lightwave Techn., 7, 11, 1641 (1989)
3.] R. C. Alferness, L. L. Buhl, U. Koren, B. I. Miller, M. G. Young, T. L. Koch, C. A. Burrus, G. Raybon, "Broadly tunable InGaAsP/InP buried rib waveguide vertical coupler filter", Appl. Phys. Lett., 60, 8, 980 (1992)
4.] Wu, C. Rolland, F. Sheperd, C. Larocque, N. Puetz, K. D. Chik, J. M. Xu, "InGaAsP/Inp Vertical Filter with Optimally Designed Wavelength Tunability", IEEE Photonics Technol. Lett., 9, 4, 957 (1993)
5.] Z. M. Chuang, L. A. Coldren "Endhanced wavelength tuning in grating assisted codirectional coupler filter", IEEE Photonics Technology Lett., 5, 10, 1219 (1993)

Weiterhin ist ein Verfahren für die Herstellung von Wellenleiterschaltungen aus polymeren Wellenleitern durch maskengestützte Belichtungsverfahren bekannt, wie es in Quelle 6.] von L- H. Lösch, P. Kersten and W. Wischmann in "Optical Waveguide Materials" (M. M. Broer, G. H. Sigel Jr., R. Th. Kersten, H. Kawazoe ed) Mat. Res. Soc. 244, Pittsburg, PA 1992, pp 253-262 beschrieben wurde.

Eine weitere bekannte Lösung basiert auf der Definition der Wellenleiter durch Einätzen einer Stufe in optisch dünnere Schichten. Ein derartiges Verfahren wurde durch 7.] K.J. Ebeling, in "Integrierte Optoelektronik" (Springer Verlag 1989) 81 beschrieben.
1. Ein weiteres bekanntes Verfahren beruht auf der Silylierung. Mit dem Silylierungsverfahren wurden bereits Wellenleiter in NOVOLAK definiert und auf ihre Anwendbarkeit in der integrierten Optik untersucht, wie in Quelle 8.] von T. Kerber, H. W. P. Koops in "Surface imaging with HMCTS on SAL resists, a dry developable electron beam process with high sensitivity and good resolution", Microelectronic Engineering 21 ((1993) 275-278 beschrieben.
2. Die dazu benötigten Verfahren zur genauen Prozeßkontrolle wurden in Quelle 9.] von H. W. P Koops, B. Fischer, T. Kerber, in "Endpoint detection for silylation processes with waveguide modes", Microelectronic Engineering 21 (1993) 235-238 und in Quelle 10.] von J. Vac, SCI Technol. B 6 (1) (1988) 477 beschrieben.

Hohe Brechzahlunterschiede können durch Implantation von Ionen mit hohen Energien und hohen Dosen in PMMA hergestellt werden. Derartige Verfahren sind in Quelle 11.] von R. Kallweit, J. P- Biersack in "Ion Beam Induced Changes of the Refractive Index of PMMA", Radiation Effects and Defects in Solidas, 1991, Vol. 116, pp 29-36 und in Quelle 12.] von R. Kallweit, U. Roll, J. Kuppe, H. Strack "Long-Term Studies on the Optical Performance of Ion Implanted PMMA Under the Influence of Different Media", Mat.Res. Soc. Symp. Proc. Vol. 338 (1994) 619-624 beschrieben worden. Dabei werden Brechzahlunterschiede im massiven PMMA-Material bis zu 20 % erreicht. Zur Strukturierung müssen allerdings maskierende Verfahren eingesetzt. Dabei ist wegen der hohen Ionen-Energie und der geforderten Absober-Schichtdicke in der Maske die Auflösung durch die in den Maskenherstellungstechnologien erreichbare Randrauhigkeit begrenzt. Elektrisch schaltbare in wellenleiter eingebaute Bereiche können durch die Eindiffusion von gepolten nichtlinear-optischen Materialien in Polymeren erzeugt werden. Auf diese Art und Weise kann die Verknüpfung zu elektrischer Einstellbarkeit optischer Wege oder der Beeinflussung optischer Vorgänge erreicht werden.
13.] M. Eich, H. Looser, D. Y. Yoon, R. Twieg, G. C. Bjorklund, "Second harmonic generation in poled organic monomeric glasses", J. Opt. Soc. Am. B, 6, 8, (1989)
14.] M. Eich, A. Sen, H. Looser, G. C. Björklund, J. D. Swalen, R. Twieg, D. Y. Yoon, "Corona Poling and Real Time Second Harmonic Generation Study of a Novel Covalently Functionalized Amorphous Nonlinear Optical Polymer", J. Appl. Phys., 66, 6 (1989)R. Birenheide,
15.] M. Eich, D. A. Jungbauer, O. Herrmann-Schönherr, K. Stoll, J. H. Wendorff, "Analysis of Reorientational Processes in Liquid Crystalline Side Chain Pollymers Using Dielectric Relaxation, Electro-Optical Relaxation and Switching Studies", Mol. Cryst. Liq. Cryst., 177, 13 (1989)
16.] M. Eich, G. C. Björklond, D. Y. Yoon, "Poled Amorphous Polymers of Second Order Nonlinear Optics", Polymers for Advanced Technologies, 1, 189 (1990)M. Stalder, P. Ehbets, "Electrically switchable diffractive optical element for image processing", Optics Letters 19, 1 (1994)
   Freie Gestaltbarkeit der Struktur wird erreicht, wenn mit dem neuartigen Verfahren der Additiven Lithographie 3-dimensionale Strukturen und periodische Anordnungen auf beliebigen, billigen Substraten aufgebaut werden und durch Materialwahl der Prekursoren der Brechungsindex des Deponats der Aufgabenstellung angepasst wird. Als Quellen zu o.g. Problematik werden [Quelle 8-16] sowie die nachfolgend aufgeführten Quellen benannt.
17.] M. Stalder, P. Ehbets, "Electrically switchable diffractive optical element for image processing", Optics Letters 19, 1 (1994)
18.] H. W. P. Koops, R. Weiel, D. P. Kern, T. H. Baum, "High Resolution Electron Beam Induced Deposition", Proc. 31. Int. Symp. On Electron, Ion, and Photon Beams, J. Vac. Sci. Technol. B 6(1) (1988) 477
19.] H. W. P. Koops, J. Kretz, M. Rudolph, M. Weber "Constructive 3-dimensional Lithography with Electron Beam Induced Deposition for Quantum Effect Devices", J. Vac. Sci. Technol. B 10(6) Nov., Dec. (1993) 2386-2389
20.] H. W. P. Koops,J. Kretz, M. Rudolph, M. Weber, G. Dahm, K. L. Lee, "Characterization and application of materials grown by electron beam induced deposition", Invited lecture Micro Process 1994, Jpn. J. Appl. Vol. 33 (1994) 7099-7107, Part. 1 No. 12B, December 1994
21.] Hans W. P. Koops, Shawn-Yu Lin, "3-Dimensional Photon Crystals Generated Using Additive Corpuscular-Beam-Lithography" Patentschrift eingereicht am 20.08.1995
   Aus Photonen-Kristallen lassen sich so schmalbandige geometrische fest einstellbare Filter und hochreflektierende Spiegel miniaturisiert aufbauen. Kombiniert man die in Depositionstechnik hergestellten Photonen-Kristalle mit nichtlinear-optischen Materialien in den Zwischenräumen der Deponate, so lassen sich miniaturisierte einstellbare optische Komponenten erzielen [Quelle 21].
   Heutige oberflächenabbildende Verfahren lassen mit optischen Phasenmasken und Steppern und mit dem Einsatz von Trocken-Ätzverfahren die für optische Gitter und andere optische Elemente erforderliche Auflösung und Höhenverhältnisse erreichen. Dazu ist die Lithographie- und Prozeß-Ausrüstung der Hersteller elektronischer Speicher, die 1 G-bit Größe und entsprechende Auflösung besitzen, in der Lage. Hochdurchsatz-Produktionsverfahren werden in korpuskularstrahl-optische Verkleinerungstechniken angewendet, wie in den folgenden Quellen ausgeführt:
23] H. Koops, 1974, DE-PS 2.446 789.8-33 "Korpuskularstrahloptisches Gerät zur Korpuskelbestrahlung eines Präparates",
24] H. Koops, 1974, DE-PS 2460 716.7 "Korpuskularstrahloptisches Gerät zur Korpuskelbestrahlung eines Präparates",
25] H. Koops, 1974, DE-PS 2460 715.6 "Korpuskularstrahloptisches Gerät zur Korpuskelbestrahlung eines Präparates in Form eines Flächenmusters mit mehreren untereinander gleichen Flächenelementen",
26] H. Koops, 1975, DE-PS 2515 550.4 "Korpuskularstrahloptisches Gerät zur Abbildung einer Maske auf ein zu bestrahlendes Präparat",
27) H. W. P. Koops, "Capacities of Electron Beam Reducing Image Projection Systems with Dynamically Compensated Field Aberrations" Microelectronic Engineering 9 (1989) 217-220
   Eine weitere bekannte Verkleinerungstechnik beruht auf Stempel-Techniken mit kleinen Masken-Schablonen wie in nachfolgenden Quellen beschrieben:
28.] H. Elsner, P. Hahmann, G. Dahm, H. W. P. Koops "Multiple Beam-shaping Diaphragm for Efficient Exposure of Gratings" J. Vac. Sci. Technol. B 0(6) Nov, Dec. (1993) 2373-2376
29.] H. Elsner, H.-J. Döring, H. Schacke, G. Dahm, H. W. P. Koops, "Advanced Multiple Beam-shaping Diaphragm for Efficient Exposure", Microelectronic Engineering 23 (1994) 85-88
   Auch durch den Einsatz der elektronenstrahlinduzierten Deposition in Projektionsgeräten läßt sich eine Verkleinerung realisieren.
30.] M. Rüb. H. W. P. Koops, T. Tschudi "Electron beam induced deposition in a reducing image projector", Microelectronic Engineering 9 (1989) 251-254

Integriert-optische Strukturen, bei welchen das Verfahren der Brechzahlmodulation durch Eindiffision von Nichtlinear-optischen-, Hochbrechzahl- oder Flüssigkristall-Monomeren in bestehende Polymere in Verbindung zu freistehenden Polymer-Strukturen angewandt wird, und der Brechzahlunterschied zum Vakuum als der wesentliche Schritt der Brechzahl-Erhöhungen eingesetzt wird, sind derzeit nicht bekannt.

Das erfindungsgemäße Verfahren zur Herstellung von aktiven und passiven optischen Komponenten basiert auf den an sich bekannten Verfahren der Oberflächenabbildung zur Herstellung einer sauerstoffresistenten Ätzmaske in unbelichteten Bereichen und der Eindiffusion von Molekülen in strukturierte Polymerschichten.

Erfindungsgemäß wird auf eine optoelektronische Komponente, bestehend aus Glas und Leiterbahn oder aus Substrat mindestens eine strukturierte Lack-Polymerschicht hoher Empfindlichkeit aus Novolak aufgebracht. Anschließend werden definierte Bereiche der Lack-Polymerschicht belichtet und so eine Ätzmaske erzeugt. Durch hochgradige anisotrophe Tiefenatzung der nicht geschützten Bereiche wird die Ätzmaske in die unter der Ätzmaske befindliche Lack-Polymerschicht übertragen. Die belichteten Bereiche der Lack-Polymerschicht werden in vertikaler Richtung abgetragen, so daß die nicht belichteten Seitenflächen der durch die Ätzmaske geschützten Bereiche freiliegen.

In dem sich anschließenden Prozess der Gasphasen- bzw. Flüssig-Phasen-Eindiffusion wird die unbelichtete Lack-Polymerschicht von ihrer Oberfläche durch die Maske der Oberflächenmaskierung und von ihren durch die Sauerstoff-Tiefenätzung freigelegten Seitenflächen unter Temperatureinwirkung mit Monomeren gefüllt. Dabei werden Monomere verwendet, die geeignet sind, die bereits vorhandene Struktur des Polymers aufzubrechen und sie umzustrukturieren, so daß sich die optischen Eigenschaften der optoelektronischen Komponente in Abhängigkeit von der Art der verwendeten Monomere, sowie der Temperatur und der Einwirkzeit gezielt verändern lassen. Im Eindiffusionsprozeß schwillt das Polymer dann allseitig und so kann der zuvor verlorene Randbereich durch das geschwollene Material gezielt und durch die Diffusions-Zeit und Temperatur gesteuert ausgeglichen werden. Zusätzlich sind die durch Schwellung entstandenen Oberflächen wegen der wirkenden Oberflächenspannung sehr glatt, d. h. Rauhtiefen im 2 nm Bereich werden erreicht. Nach der Diffusion ausgeführtes UV-Härten und Tiefenvernetzen der eindiffundierten Moleküle sichert das erreichte Brechzahlprofil auch langfristig.
Durch die Eindiffusion von schwermetalloxidhaltigen, nichtlinear-optischen oder Flüssigkristall-Monomeren oder auch "Seltene Erden" enthaltende Moleküle in die freigelegten tiefen Polymer-Strukturen können nun neben passiven auch nichtlinear-optisch aktive Materialien in ausgewählten Bereichen erzeugt werden. Damit ist die Herstellung von eindiffundierten Brechzahlprofilen in durch optische und Korpuskularstrahl-Lithographie definierte Bereiche möglich.

Die erfindungsgemäße Lösung soll anhand eines Ausführungsbeispiels näher erläutert werden.

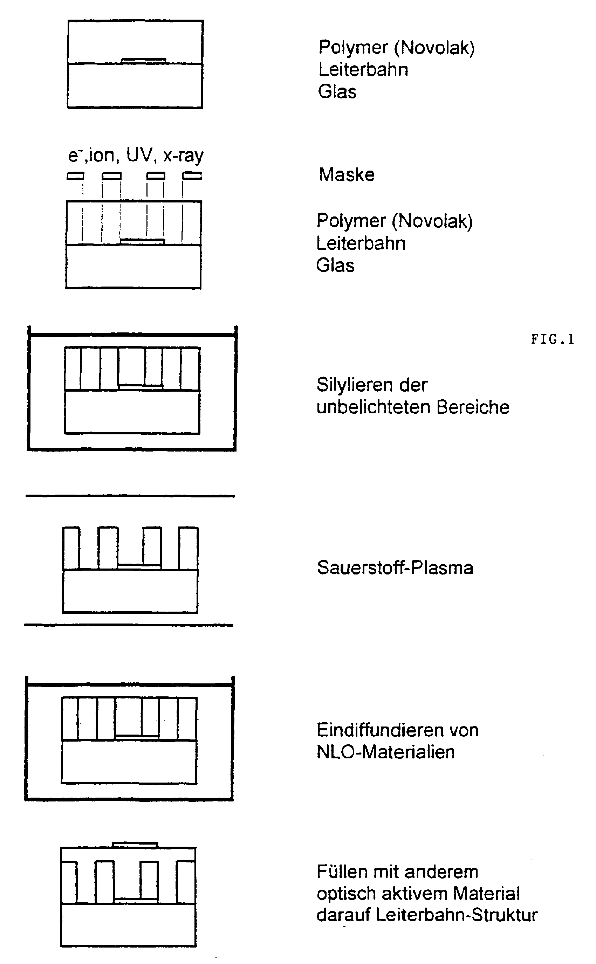

In Fig. 1 ist das Schema der Herstellung von Brechzahlprofil-Strukturen mit Hilfe der chemischen Eindiffusion im erweiterten Silylierungsprozess dargestellt.

Auf dem aus Glas und Leiterbahn aufgebauten Grundkörper wird eine strukturierbare Polymerschicht hoher Empfindlichkeit aus Novolak aufgebracht. Die Ätzmaske wird durch Belichtung definierter, dem späteren Bauelement entsprechender Bereiche der Lack-Polymerschicht in Verbindung mit einem Silylierungsprozess der unbelichteten Bereiche erzeugt. Durch die Kombination des Silylierungsverfahrens zur hochauflösenden Strukturdefinition mit dem Trockenätzen der vernetzten Polymere zur Herstellung der großen Höhen zu Breitenverhältnisse der Strukturen wird erreicht, daß das unvernetzte/unbelichtete Material zu weiteren chemischen Eindiffusion von Monomeren für die verschiedenen gewünschten Effekte zur Verfügung steht. Bei der Belichtung von negativ arbeitendem Novolak wird dieser Teil des Materials normalerweise im Entwicklungsprozeß herausgelöst. Durch die Silylierung bleibt er nach dem Trockenätzen bestehen. Wird der Silylierungsprozeß mit einem kurzen isotropen das Siliziumoxid der Silylierungsmaske angreifenden Prozess begonnen, so weitet sich zwar die Struktur, jedoch wird die durch den "shot-noise" der Elektronenbelichtung im Randbereich der Maske erhaltene rauhe Kantenstruktur des silylierten Bereiches geglättet.

Damit können im nachfolgenden anisotropen Trockenätzprozeß, bei dem ein Ätzmittel verwendet wird, welches das Silizium-Oxid der Ätzmaske angreift, mit gerichteten Sauerstoffionen glatte Seitenwände des Polymers erzielt werden. Damit wird das bei Korpuskularstrahloptik unvermeidliche "shot-noise"-Randrauhigkeitsproblem gelöst. Auf diese Weise werden auch die an den rauhen Flächen zu erwartenden Streuverluste minimiert.
Im anschließenden Eindiffusionsprozeß schwillt das Polymer dann allseitig, so daß der zuvor verlorene Randbereich durch das geschwollene Material und durch die Diffusions-Zeit und die Temperatur gesteuert ausgeglichen werden kann. Durch die Eindiffusion von schwermetall-oxid-haltigen Verbindungen, nichtlinear-optischen Verbindungen oder anderen ähnlich gearteten Verbindungen oder auch durch die Eindiffusion von in "Seltene Erden" enthaltenen Molekülen in die freigelegte tiefe Polymer-Strukturen können nun neben passiven auch nichtlinear-optisch aktive Materialien in ausgewählten Bereichen erzeugt werden. Damit ist die Herstellung von eindiffundierten Brechzahlprofilen in durch optische und Korpuskular-Lithographie definierte Bereiche möglich. Diese Eindiffusion kann wie herkömmlich in ungeätzte Polymerschichten erfolgen, was zu Brechzahlunterschieden bis 10 % führt. Wird die Eindiffusion in durch naßchemisches Entwickeln oder durch Trockenätzen bereits strukturierten Polymerschichten durchgeführt, so können Brechzahlunterschiede von 1,5 bis 3 erzeugt werden.
Mit diesem Verfahren kann der Brechungsindex-Unterschied von 10⁻³ bis 10⁻⁴ im Fall von mit UV- und Elektronen belichtetem Plexiglas auf 0.06 als Brechzahlunterschied zwischen silyliertem und unsilyliertem Novolak gesteigert werden. Die erzielten Brechzahlunterschiede können noch weiter dadurch gesteigert werden, daß die durch den Belichtungsprozeß negativ polymerisierten Lackbereiche durch Sauerstoff-Trockenätzen mit hoher Auflösung aus der optisch aktiven und passiven Struktur herausgelöst werden, und so Brechzahlunterschiede zum Vakuum n = 1 entstehen. Im Fall des freistehenden silylierten Bereiches vergrößert sich der Brechzahlunterschied auf 1,57, während er für das unsilylierte Material 1,63 beträgt. Damit besteht die fertige Komponente aus chemisch inerten abgesättigten Stoffen glasartiger Zusammensetzung und guter Beständigkeit. Die eindiffundierten Bereiche können durch UV-Tiefenvernetzung langzeitstabil vernetzt werden, was eine hohe Lebensdauer der Bauelemente ermöglicht. Die Mischung von elektrischen und integriert-optischen Bauelementen in den Schichten des Bauelementes ist ohne Schwierigkeit möglich, da es sich bei dem Verfahren um in der Lithographie seit Jahren eingesetzte Prozesse handelt. Die Herstellung ist beschleunigt, da die Novolak-Lacksysteme sich im Vergleich zu PMMA(Plexiglas) durch ca. 20-fach höhere Empfindlichkeit auszeichnen. Der Sauerstoff-Atzprozess tempert zusätzlich die mit Chemikalien eindiffundierten Bereiche und sichert so die Beständigkeit der Komponenten.
Mit dem erfindungsgemäßen Verfahren können beugende Strukturen hoher Güte und Effektivität mit wenigen Gitterebenen oder Strichen erzeugt und so integriert-optische Bauelemente wie Koppler, Gitter, Selektoren und Reflektoren mit wenigen Gitterperioden hergestellt werden. Bei der Verwendung so hoher Brechzahlunterschiede in den optischen Strukturen und Gittern lassen sich dieselben optischen Güten mit viel kürzeren Bauelementen als es mit der Polymer-Plexiglas-Technik möglich ist, erzielen. Damit wird die Packungsdichte der integriert optischen Elemente in der miniaturisierten integrierten Optik stark erhöht. Für die Realisierung der erfindungsgemäßen optischen Komponenten in größerem Umfang werden folgende Möglichkeiten gesehen:
1. Durch strahlführende oder Stempelmasken projizierende Lithographiegeräte mit variabel geformten Strahl könnten in kurzen Zeiten schnelle Entwicklungsschritte in der Technik in geringen Stückzahlen durchgeführt werden.
2. Eine Massenproduktion der erfindungsgemäßen optoelektronischen Komponenten läßt sich vorzugsweise mit den aus dem optischen Speicherbau bekannten herkömmlichen Lithographieverfahren, wie Korpuskularstrahl- und optische Schablonen-Projektions-Techniken und optische Masken-Projektions-Techniken inklusive der Röntgen-LithographieVerfahren kostengünstig realisieren.

Das Verfahren ermöglicht die Erhöhung der Packungsdichte zukünftiger integrierter Monomode-Optik bei gleichzeitiger kostengünstiger Herstellung großer Stückzahlen.

## Patentansprüche

1. Verfahren zur Herstellung von aktiven bzw. passiven Komponenten auf Polymerbasis für die integrierte Optik unter Einbeziehung des Prinzips der Gasphasen- bzw. Flüssig-Phasen-Eindiffusion, **dadurch gekennzeichnet,**
- **daß** auf eine optoelektronische Komponente mindestens eine strukturierbare Lack-Polymerschicht hoher Empfindlichkeit aus Novolack, aufgebracht wird,
- **daß** durch Belichtung definierter, dem späteren Bauelement entsprechender Bereiche der Lack-Polymerschicht, eine Ätzmaske erzeugt wird,
- **daß** die Geometrie der Ätzmaske durch hochgradig anisotrope Tiefenätzung in die nicht geschützten Bereiche der unter der Ätzmaske befindlichen Lack-Polymerschicht übertragen wird, wobei ein Ätzmittel verwendet wird, welches das Siliziom-Oxid der Ätzmaske nicht angreift, wodurch die belichteten Bereiche der Lack-Polymerschicht in vertikaler Richtung abgetragen und die Seitenflächen der durch die Ätzmaske geschützten Bereiche freigelegt werden,
- **daß** die unbelichtete Lack-Polymerschicht von ihrer Oberfläche durch die Maske der Oberflächenmaskierung und von ihren durch die Tiefenätzung freigelegten Seitenflächen, durch Gasphasen- bzw. Flüssig-Phasen-Eindiffusion unter Temperatureinwirkung mit **Monomeren** gefüllt wird, die geeignet sind, die bereits vorhandene Struktur des Polymers zu füllen, sie aufzubrechen und sie umzustrukturieren, wobei sich die optischen Eigenschaften der optoelektronischen Komponente in Abhängigkeit von der Art der für die Dotierung verwendeten monomeren Verbindungen, sowie der Temperatur und der Einwirkzeit gezielt verändern lassen.

2. Verfahren nach Anspruch 1, **dadurch gekennzeichnet, dass** die unbelichtete Lack-Polymerschicht mit in monomerer Form vorliegenden schwermetalloxidhaltigen Verbindungen gefüllt wird.

3. Verfahren nach Anspruch 1, **dadurch gekennzeichnet, dass** die unbelichtete Lack-Polymerschicht mit nichtlinear-optischen Monomeren gefüllt wird.

4. Verfahren nach Anspruch 1, **dadurch gekennzeichnet, dass** die unbelichtete Lack-Polymerschicht mit Flüssigkristall-Monomeren gefüllt wird.

5. Verfahren nach Anspruch 1, **dadurch gekennzeichnet, dass** die unbelichtete Lack-Polymerschicht mit seltene Erden enthaltenden Molekülen gefüllt wird.

6. Verfahren nach Anspruch **1 bis 5, dadurch gekennzeichnet, daß** die beim Eindiffusionsprozeß zwangsläufig auftretende Materialschwellung gezielt über die Diffusions-Zeit und die Prozeßtemperatur gesteuert wird, bis die Struktur-Ungenauigkeiten wieder ausgeglichen sind.

7. Verfahren nach Anspruch **1 bis 5, dadurch gekennzeichnet, daß** durch die Verwendung von Vakuum bzw. Luft bei Normaldruck in den Zwischenräumen der strukturierten Lack- Polymerschicht ein Brechzahlunterschied >1,5 zu den Strukturen im gefüllten Polymer eingestellt wird.

8. Verfahren nach Anspruch **1 bis 5, dadurch gekennzeichnet, daß** die mit monomeren Verbindungen gefüllte Polymer-Struktur mit elektrischen Elektroden umgeben und daß über die Steuerung des zwischen den elektrischen Elektroden anliegenden elektrischen Feldes die Polymer-Struktur in ihren optischen Eigenschaften eingestellt wird.

9. Verfahren nach Anspruch **1 bis 5, dadurch gekennzeichnet, daß** die mit monomeren Verbindungen gefüllte Polymer-Struktur an Wellenleiter angeschlossen wird, durch die Licht in die Polymer-Struktur eingekoppelt wird und daß über die Veränderung des eingekoppelten Lichtes die Polymer-Struktur in ihren optischen Eigenschaften eingestellt wird.

10. Verfahren nach Anspruch **1 bis 5, dadurch gekennzeichnet, daß** die Ätzmaske durch Belichtung definierter, dem späteren Bauelement entsprechender Bereiche der Lack-Polymerschicht in Verbindung mit der Silylierung der nicht belichteten Bereiche der Lack-Polymerschicht erzeugt wird, und daß die Ätzmaske nach der Silylierung mit einem isotropen Ätzangriff, unter Anwendung eines das Silizium-Oxid der Ätzmaske angreifenden Mittels, an ihren Rändern geglättet wird.

## Claims

1. Method for fabricating active and passive polymer-based components for use in integrated optics, incorporating the principle of gas-phase or liquid-phase diffusion, **characterized in that**
- at least one highly sensitive, structurable polymer resist layer of Novolack is deposited onto an optoelectronic component,
- **in that** an etching mask is produced by exposing defined regions of the polymer resist layer corresponding to the future component,
- **in that** the geometry of the etching mask is transferred to the unprotected regions of the polymer resist layer located under the etching mask by highly anisotropic deep etching, wherein an etchant is used that does not attack the silicon dioxide of the etching mask, by which means the exposed regions of the polymer resist layer are removed in the vertical direction and the side surfaces of the regions protected by the etching mask are uncovered,
- **in that** gas-phase or liquid-phase diffusion with the application of heat is used to fill the unexposed polymer resist layer, from its surface through the mask of the surface masking and from its side surfaces uncovered by the deep etching, with monomers that are suitable for filling the existing structure of the polymer, breaking it up, and restructuring it, wherein the optical properties of the optoelectronic component can be selectively altered as a function of the type of monomer compounds used for the doping, and of the temperature and application time.

2. Method according to claim 1, **characterized in that** the unexposed polymer resist layer is filled with compounds in monomer form containing heavy metal oxides.

3. Method according to claim 1, **characterized in that** the unexposed polymer resist layer is filled with monomers having nonlinear optical properties.

4. Method according to claim 1, **characterized in that** the unexposed polymer resist layer is filled with liquid-crystal monomers.

5. Method according to claim 1, **characterized in that** the unexposed polymer resist layer is filled with molecules containing rare earth elements.

6. Method according to any one of claims 1 through 5, **characterized in that** the material swelling inevitably occurring during the diffusion process is selectively controlled by means of the diffusion time and the process temperature until the structural inaccuracies have been compensated.

7. Method according to any one of claims 1 through 5, **characterized in that** vacuum or air at standard pressure is used in the intermediate spaces of the structured polymer resist layer to establish a difference in refractive index of >1.5 with respect to the structures in the filled polymer.

8. Method according to any one of claims 1 through 5, **characterized in that** the polymer structure filled with monomer compounds is surrounded by electrical electrodes and **in that** the optical properties of the polymer structure are adjusted by controlling the electric field applied between the electrical electrodes.

9. Method according to any one of claims 1 through 5, **characterized in that** the polymer structure filled with monomer compounds is connected to waveguides through which light is coupled into the polymer structure, and **in that** the optical properties of the polymer structure are adjusted by changing the light that is coupled in.

10. Method according to any one of claims 1 through 5, **characterized in that** the etching mask is produced by exposing defined regions of the polymer resist layer corresponding to the future component in conjunction with sylilation of the unexposed regions of the polymer resist layer, and **in that**, after sylilation, the edges of the etching mask are smoothed by isotropic etching using an agent that attacks the silicon dioxide of the etching mask.

## Revendications

1. Procédé de fabrication de composants actifs ou passifs à base de polymère destiné à l'optique intégrée associé au principe de la pénétration par diffusion en phase gazeuse ou en phase liquide, **caractérisé**
- **en ce qu'**au moins une couche de vernis polymère structurable de grande sensibilité de type novolaque est appliquée sur un composant optoélectronique,
- **en ce qu'**un masque de gravure est généré par exposition de régions définies de la couche de vernis polymère correspondant au futur composant,
- **en ce que** la géométrie du masque de gravure est reproduite dans les régions non protégées de la couche de vernis polymère située sous le masque de gravure par gravure profonde hautement anisotrope, une solution d'attaque étant utilisée qui n'attaque pas l'oxyde de silicium du masque de gravure, permettant de dissoudre les régions exposées de la couche de vernis polymère dans le sens vertical et de dénuder les faces latérales des régions protégées par le masque de gravure,
- **en ce que** la couche de vernis polymère non exposée est remplie, à partir de sa surface, à travers le masque du masquage de surface, et à partir de ses faces latérales dénudées par la gravure profonde, par pénétration par diffusion en phase gazeuse ou en phase liquide sous l'effet de la température, de monomères aptes à remplir la structure existante du polymère, à la casser et la restructurer, les propriétés optiques du composant optoélectronique pouvant être modifiées de manière ciblée en fonction du type des composés monomères utilisés pour le dotage ainsi qu'en fonction de la température et du temps d'action.

2. Procédé selon la revendication 1, **caractérisé en ce que** la couche de vernis polymère non exposée est remplie de composés à teneur en oxydes de métaux lourds sous forme monomère.

3. Procédé selon la revendication 1, **caractérisé en ce que** la couche de vernis polymère non exposée est remplie de monomères à optique non linéaire.

4. Procédé selon la revendication 1, **caractérisé en ce que** la couche de vernis polymère non exposée est remplie de monomères à cristaux liquides.

5. Procédé selon la revendication 1, **caractérisé en ce que** la couche de vernis polymère non exposée est remplie de molécules contenant des terres rares.

6. Procédé selon les revendications 1 à 5, **caractérisé en ce que** le gonflement de matière apparaissant forcément au cours du processus de pénétration par diffusion est commandé de manière ciblée par l'intermédiaire de la durée de diffusion et de la température de processus jusqu'à ce que les imprécisions structurelles soient compensées.

7. Procédé selon les revendications 1 à 5, **caractérisé en ce que** l'utilisation de vide ou d'air à pression normale permet de régler, dans les interstices de la couche de vernis polymère structurée, une différence d'indice de réfraction > 1,5 par rapport aux structures dans le polymère rempli.

8. Procédé selon les revendications 1 à 5, **caractérisé en ce que** la structure polymère remplie de composés monomères est entourée d'électrodes électriques et **en ce que** le réglage des propriétés optiques de la structure polymère s'obtient par la commande du champ électrique existant entre les électrodes électriques.

9. Procédé selon les revendications 1 à 5, **caractérisé en ce que** la structure polymère remplie de composés monomères est raccordée à des guides d'onde, au travers desquels de la lumière est injectée dans la structure polymère, et **en ce que** le réglage des propriétés optiques de la structure polymère s'obtient par modification de la lumière injectée.

10. Procédé selon les revendications 1 à 5, **caractérisé en ce que** le masque de gravure est généré par exposition de régions définies de la couche de vernis polymère correspondant au futur composant combinée à la silylation des régions non exposées de la couche de vernis polymère, et **en ce que**, après silylation, le masque de gravure est aplani au niveau de ses bords moyennant une attaque isotrope en utilisant un agent attaquant l'oxyde de silicium du masque de gravure.
